# EUROPÄISCHE PATENTSCHRIFT

(11) **EP 1 241 714 B1**
(45) Veröffentlichungstag und Bekanntmachung des Hinweises auf die Patenterteilung: **17.12.2003**
(21) Anmeldenummer: 01105954.0
(22) Anmeldetag: 09.03.2001
(51) Int. Cl.: H01L 41/09, G01N 27/00, B25J 7/00, G02B 21/32

(54) **Positioniereinheit und Positioniereinrichtung mit mindestens zwei Positioniereinheiten**
Positioning unit and positioning device having at least two positioning units
Unité de positionnement et dispositif de positionnement avec au moins deux unités de positionnement

(43) Veröffentlichungstag der Anmeldung: 18.09.2002
(73) Patentinhaber: Klocke Nanotechnik, 52076 Aachen (DE)
(72) Erfinder: Klocke, Volker, Dr., 51107 Köln (DE)
(74) Vertreter: Castell, Klaus, Dr.-Ing.

(56) Entgegenhaltungen:
- EP-A- 0 935 137
- EP-B- 0 611 485
- WO-A-00/77553
- DE-A- 4 440 758
- DE-A- 19 744 126
- DE-A- 19 916 277
- FR-A- 933 509
- GB-A- 1 501 253
- US-A- 5 223 713
- KARIDIS J P ET AL: "THE HUMMINGBIRD MINIPOSITIONER - PROVIDING THREE-AXIS MOTION AT 50 G'S WITH LOW REACTIONS" PROCEEDINGS OF THE INTERNATIONAL CONFERENCE ON ROBOTICS AND AUTOMATION NICE, MAY 12 - 14, 1992, LOS ALAMITOS, IEEE COMP. SOC. PRESS, US, Bd. 1 CONF. 8, 12. Mai 1992 (1992-05-12), Seiten 685-692, XP000300541 ISBN: 0-8186-2720-4

## Beschreibung

Die Erfindung betrifft eine Positioniereinheit mit einem Beschleunigungsnanoantrieb, der eine Auflösung von mindestens ±10 nm aufweist und auf einen Läufer nach dem Prinzip des Trägheitsantriebs oder durch Erzeugung mechanischer Pulswellen Beschleunigungen von über 10 G aufbringen kann und einem Modul, das eine zu positionierende bewegliche Komponente aufweist, die eine Masse von unter 500 g aufweist und relativ zum Antrieb beweglich gelagert ist. Außerdem betrifft die Erfindung eine Positioniereinrichtung mit mindestens zwei derartigen Positioniereinheiten.

Derartige Positioniereinheiten werden beispielsweise dazu verwendet, unter einem Mikroskop das beobachtete Objekt zu bewegen. Hierbei kommt es darauf an, dass der Antrieb eine vorgegebene Position mit einer besonders hohen Auflösung ansteuert. Dies wird dadurch erzielt, dass der Antrieb auf einen Läufer Beschleunigungen ausübt und dadurch den Läufer relativ zum Antrieb bewegt.

In der Regel wird die hohe Auflösung dadurch erzielt, dass der Läufer wiederholt nur eine besonders kurze Strecke bewegt wird. Diese Strecke liegt im Nanometerbereich und durch eine Vielzahl derartiger kleiner Bewegungsschritte kann der Läufer mit extrem hoher Auflösung positioniert werden.

Bei derartigen Nanoantrieben werden klammernde und beschleunigende Verfahren unterschieden. Bei klammernden Verfahren wird der Läufer gegriffen, um die kleine Wegstrecke bewegt und wieder losgelassen. Die Klammer fährt schnell in die Ausgangsposition zurück und greift den Läufer erneut, um einen weiteren Vorschub wieder im Nanometerbereich zu erzielen.

Die andere Gruppe der Nanoantriebe nutzt als Antriebsprinzip relativ hohe Beschleunigungen, die in der Regel über 10 G liegen. Dabei kann es sich um Trägheitsantriebe oder um Antriebe handeln, welche ihre bewegliche Komponente, das heißt den Läufer, durch mechanische Pulswellen beschleunigen. Diese Gruppe der Nanoantriebe ist in der Regel einfacher im Aufbau und daher als kleinere Baueinheit ausführbar. Besonders kompakte Bauformen solcher Nanoantriebe sind in der DE 38 44 821 C2, der EP 0 611 485 B1 und in der DE 44 40 758 A1 beschrieben. Diese Art der Nanoantriebe wird im Folgenden als Beschleunigungsnanoantrieb bezeichnet.

Es besteht ein großes Interesse daran, die genannten kompakten Beschleunigungsnanoantriebe dazu zu verwenden, die bewegliche Komponente eines Moduls, die eine Masse von unter 500 g aufweist und die relativ zum Antrieb gelagert ist, zu positionieren.

Es hat sich jedoch herausgestellt, dass die Beschleunigungsnanoantriebe hierzu nicht geeignet sind.

Wenn derartige Module mit einem Beschleunigungsnanoantrieb in Berührung gebracht werden, kommt es auch bei ordnungsgemäßer Auslegung der Komponenten zu keiner technisch nutzbaren Kraftübertragung zwischen dem Beschleunigungsnanonantrieb und der beweglichen Komponente des Moduls. Selbst wenn der Beschleunigungsnanoantrieb ein Vielfaches der Kraft ausüben kann, die zur Beschleunigung der beweglichen Komponente des Moduls notwendig wäre, wird der Beschleunigungsnanoantrieb ausgebremst, sobald er die bewegliche Komponente des Führungsmoduls berührt.

Alle Versuche, einen Beschleunigungsnanoantrieb für die Positionierung einer derart leichten beweglichen Komponente zu nutzen, scheiterten daran, dass eine Vergrößerung des Antriebs zunächst zu keinem Erfolg führte und ab einer bestimmten Antriebsgröße Antrieben mit Klammerbewegung der Vorzug gegeben wurde.

Der Erfindung liegt daher die Aufgabe zugrunde, eine gattungsgemäße Positioniereinheit derart weiterzubilden, dass Beschleunigungsnanoantriebe verwendet werden können.

Diese Aufgabe wird durch die Merkmale des Anspruchs 1 gelöst und insbesondere dadurch, dass der Läufer und die bewegliche Komponente des Moduls fest miteinander verbunden sind.

Überraschender Weise hat sich herausgestellt, dass bei einer festen Verbindung zwischen Läufer und beweglicher Komponente des Moduls die gesamte Leistungsfähigkeit des Antriebs genutzt werden kann, obwohl Versuche mit Beschleunigungsantrieben, bei denen der Antrieb an die bewegliche Komponente des Moduls gehalten wurde, fehl schlugen.

Die Nanoantriebe einsetzenden Feinmechaniker hatten - wie bei der Verwendung derartiger Stellantriebe üblich ist - zunächst in einem losen Aufbau das Zusammenwirken von Antrieb und Modul getestet, bevor sie die Einheiten fest miteinander verbunden haben. Bei diesen Tests waren regelmäßig die Beschleunigungsantriebe den klammernden Antrieben unterlegen und daher wurden für gattungsgemäße Positioniereinheiten nur klammernde Antriebe verwendet. Dies führte zu der Erkenntnis der Praktiker, dass Beschleunigungsantriebe mit Nanometerpräzision zur Positionierung von beweglichen Modul Komponenten mit einer Masse von unter 500 g nicht geeignet sind.

Entgegen dieser Erkenntnis wurden erfindungsgemäß Läufer und bewegliche Komponente des Moduls fest miteinander verbunden, obwohl Vorversuche mit losen Anordnungen scheiterten.

Die Erfindung ermöglicht somit einen besonders kompakten Aufbau von Positioniereinheiten durch die Verwendung von Beschleunigungsnanoantrieben mit besonders kompakten Bauformen.

Besonders vorteilhaft in der Praxis ist die Verwendung von Antrieben, die eine Positionierstrecke von mehr als 1 mm ermöglichen. Dadurch wird eine einfache Stellpositionierung in einem größeren Bewegungsfeld erreicht.

Für viele technische Anwendungen ist es vorteilhaft, wenn der Antrieb eine Auflösung von mindestens ± 1 nm aufweist. Eine über 1 nm hinausgehende Auflösung ermöglicht den Einsatz bei verschiedenartigsten Anwendungen in der Mikrostelltechnik.

Um einen effektiven Antrieb zu erzielen, wird vorgeschlagen, dass der Antrieb Beschleunigungen von über 20 G, vorzugsweise über 40 G auf den Läufer ausüben kann. Die Beschleunigungen liegen bei einem bevorzugten Ausführungsbeispiel unter 500 G, vorzugsweise unter 200 G, typischer Weise in einem Bereich zwischen 50 und 100 G. In der Regel bildet die über der Zeit aufgetragene Beschleunigung eine Sägezahnlinie. Die Beschleunigung kann aber auch mit weicheren Kurvenformen, wie beispielsweise mit abgerundeten Kurvenbögen auf den Läufer aufgebracht werden.

Die erfindungsgemäß aufgebrachte Beschleunigung auf den Läufer liegt in Abgrenzung zur quasistatischen Klammerbewegung oberhalb von 10 G.

Die beweglichen Komponenten der Module können mit Kugeln, Walzen oder Nadeln gelagert werden. Eine Lagerung über Gleitflächen, Luftströmung oder magnetische, elektrische oder elektromagnetische Felder ist ebenfalls möglich. Das Modul weist eine oder mehrere sehr leicht bewegliche Komponente(n) auf, die auf einer oder mehreren relativ zu einem Bezugssystem ortsfesten Komponente(n) gelagert sind. Hierbei ist es vorteilhaft, wenn die bewegliche Komponente des Moduls im Hinblick auf mehrere Freiheitsgrade beweglich gelagert ist. Dies ermöglicht es, beispielsweise mehrere Antriebe an einem Modul angreifen zu lassen, um die bewegliche Komponente des Moduls mit hoher Auflösung in eine gewünschte Raumposition zu bringen.

Ein kompakter, kleiner Aufbau ist vor allem dann zu erzielen, wenn die bewegliche Komponente des Moduls eine Masse von unter 100 g aufweist. In der Praxis hat sich herausgestellt, dass funktionale Einheiten vor allem mit beweglichen Modulkomponenten aufzubauen sind, die eine Masse von über 0,2 g aufweisen.

Als feste Verbindung eignen sich verschiedenartigste Verbindungsarten wie Kleben, Löten, Schweißen, Anschrauben, Klemmen oder Fügen. Auch lösbare feste Verbindungen, wie beispielsweise magnetische Verbindungen, zählen zu den erfindimgsgemäß vorgeschlagenen Verbindungsarten.

Vorteilhaft ist es, wenn die feste Verbindung im Wesentlichen spiel- und dämpfungsfrei ist. Dies erhöht die Sicherheit der Kraftübertragung vom Antrieb auf das Modul.

Die der Erfindung zugrundeliegende Aufgabe wird auch mit einer Positioniereinrichtung mit mindestens zwei erfindungsgemäßen Positioniereinheiten gelöst, die fest mit der beweglichen Komponente des Moduls verbunden sind. Die Verwendung mehrerer Positioniereinheiten ermöglicht den Aufbau eines xy-Tisches, eines xyz-Standes, eines Kipptisches, eines Goniometers, eines Rotationselementes, eines Portalsystems oder eines Roboters. Hierbei können die Positioniereinheiten als lateraler oder rotatorisch wirkender Antrieb verwendet werden.

Es versteht sich, dass die feste Verbindung zwischen Läufer und beweglicher Modulkomponente durch eine direkte Verbindung von Läufer und beweglicher Modulkomponente erzielt werden kann und dass ebenso ein Zwischenelement oder ein Gelenk zwischen den Läufer und die bewegliche Komponente des Moduls gesetzt werden kann, das mit dem Läufer und der beweglichen Modulkomponente fest verbunden ist. Hierbei können Antriebe und Module nebeneinander oder hintereinander angeordnet werden oder teilweise nebeneinander und teilweise hintereinander.

Anhand von verschiedenen Ausführungsbeispielen wird im Folgenden die Erfindung näher erläutert. Es zeigt
- Figur 1: schematisch das Zusammenwirken eines Beschleunigungsnanoantriebs mit einem Linearführungsmodul,
- Figur 2: schematisch das Zusammenwirken eines Beschleunigungsnanoantriebs mit einem Linearführungsmodul, die über ein Verbindungselement gekoppelt sind,
- Figur 3: schematisch das Zusammenwirken eines Beschleunigungsnanoantriebs mit einem Führungsmodul unter Zwischenschaltung eines Gelenkelementes,
- Figur 4: schematisch das Zusammenwirken zweier Beschleunigungsnanoantriebe mit einem als xy-Tisch ausgeführten Führungsmodul und
- Figur 5: schematisch das Zusammenwirken eines Beschleunigungsnanoantriebes mit zwei Führungsmodulen.

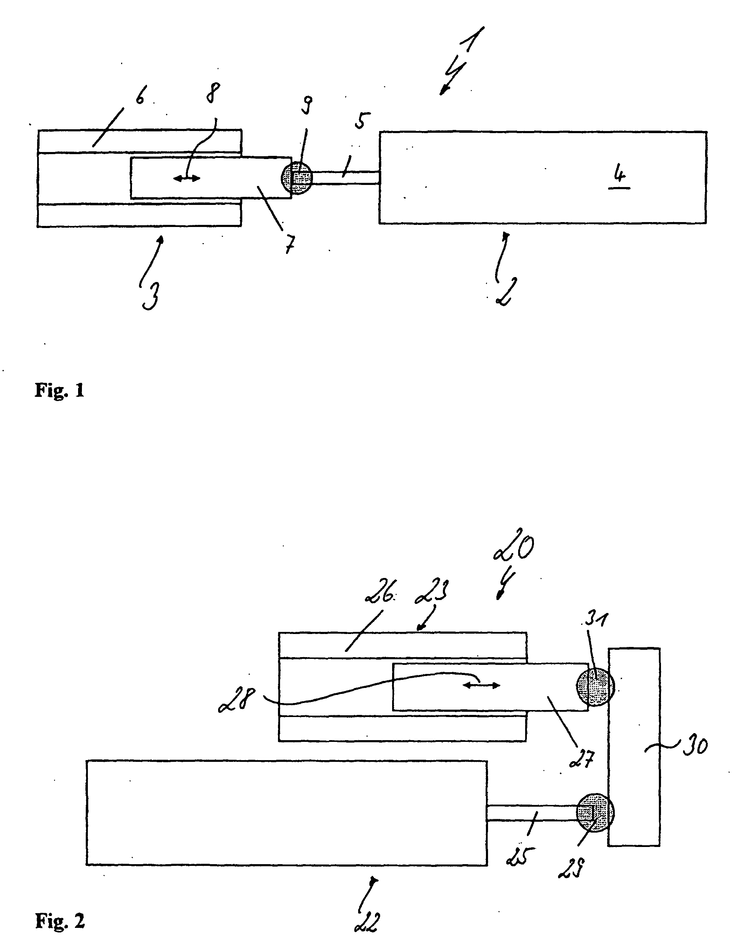

Die in Figur 1 gezeigte Positioniereinheit 1 weist einen Antrieb 2 und das Führungsmodul 3 auf. Der Antrieb 2 besteht im Wesentlichen aus dem Aktor 4 und dem Läufer 5. Das Führungsmodul 3 besteht aus der stationären Komponente 6 und der hierzu beweglichen Komponente 7. Im vorliegenden Fall ist die bewegliche Komponente 7 entsprechend den Pfeilen 8 relativ zur stationären Komponente 6 auf einer geraden Linie verschiebbar. Die bewegliche Komponente 7 des Führungsmoduls 3 ist über eine feste Verbindung - wie im vorliegenden Fall eine Schweißnaht - mit dem Läufer 5 des Nanoantriebs 2 verbunden.

Obwohl bei einer losen Verbindung von Nanoantrieb 2 und der beweglichen Komponente 6 des Führungsmoduls 3 keine technisch nutzbare Kraftübertragung zu erzielen ist, ermöglicht der Aufbau allein durch das Einführen der festen Verbindung 9 den Einsatz des Bewegungsantriebs in Verbindung mit einem derartigen Modul.

Eine weitere Ausgestaltungsform zeigt Figur 2. Bei dieser Anordnung 20 wirkt der Läufer 25 des Antriebs 22 auf eine erste feste Verbindung 29, die den Läufer 25 mit einem Verbindungselement 30 verbindet. Das Verbindungselement 30 ist über eine weitere Verbindung 31 mit der beweglichen Komponente 27 des Führungsmoduls 23 verbunden. Dies erlaubt es, das Führungsmodul und den Antrieb nebeneinander anzuordnen.

Bei einer Bewegung des Läufers 25 wird somit über das Verbindungselement 30 die bewegliche Komponente 27 des Führungsmoduls 23 relativ zur stationären Komponente 26 in Richtung des Pfeils 28 bewegt.

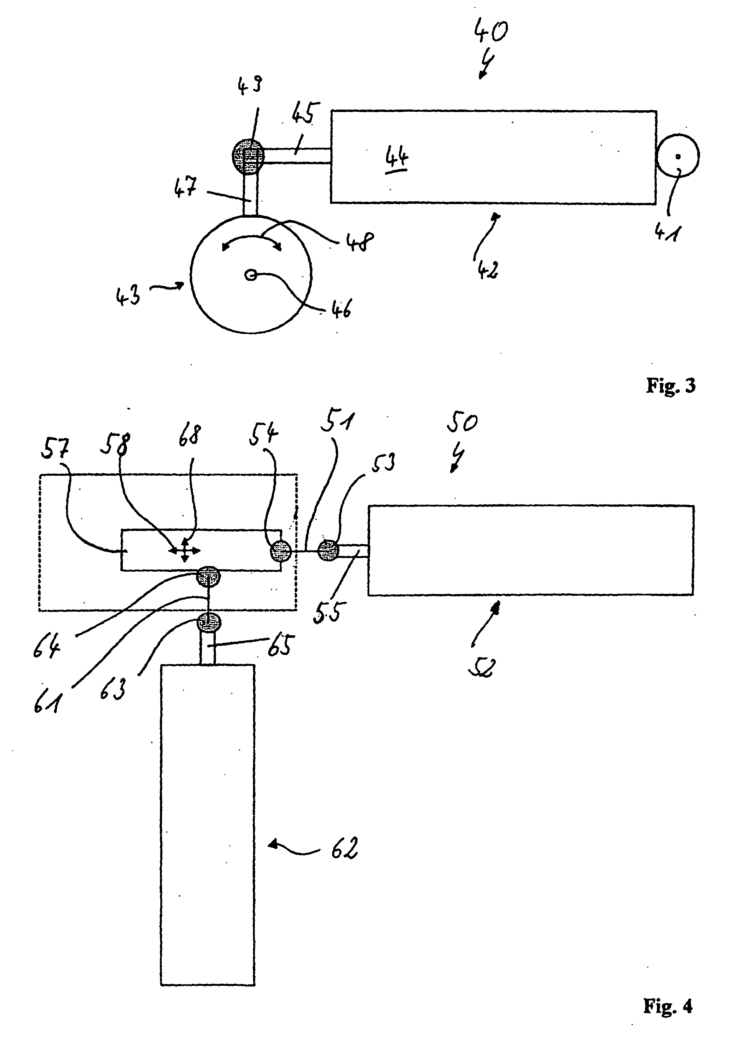

Ein weiteres Ausführungsbeispiel einer erfindungsgemäßen Positioniereinheit ist in der Figur 3 dargestellt. Bei dieser Anordnung 40 wirkt der Läufer 45 des Antriebs 42 auf die bewegliche Komponente 47 einer stationären Drehachse 46 des Drehgelenkes 43. Die Verbindung zwischen dem Läufer 45 und der beweglichen Komponente 47 des Drehgelenks 43 ist im vorliegenden Fall ein Drehgelenk 49, das eine beliebige Winkelstellung zwischen dem Läufer 45 und der beweglichen Komponente 47 zulässt, aber eine feste Verbindung dieser Teile sicherstellt. Der Antrieb 42 ist am Lager 41 drehbeweglich angebracht.

Bei einer Bewegung des Läufers 45 relativ zum Aktor 44 des Antriebs 42 wird somit die bewegliche Komponente 47 des Drehgelenks 43 um die Drehachse 46 entsprechend dem Pfeil 48 gedreht.

Die Figur 4 zeigt die Verwendung einer erfindungsgemäßen Positioniereinheit für einen xy-Tisch als Anordnung 50. Die Antriebe 52 und 62 wirken mit ihren Läufern 55 bzw. 65 jeweils auf ein Verbindungselement 51 bzw. 61. Diese Verbindungselemente 51 bzw. 61 sind im Wesentlichen orthogonal zueinander angeordnet und mit der beweglichen Komponente 57 des xy-Tisches 58 verbunden. Um eine Bewegung der beweglichen Komponente 57 sowohl in Richtung der Pfeile 58 als auch in Richtung der dazu senkrecht angeordneten Pfeile 68 zu ermöglichen, sind die Verbindungen 51 und 61 als zumindest leicht seitlich flexibles Element ausgebildet. Diese Verbindungselemente 51 bzw. 61 können als einfacher Draht, als Blattfeder oder als komplexes mechanisches Gelenk mit Lager und Gegenlager ausgebildet sein. Die bewegliche Komponente 57 ist mit dem xy-Tisch über eine Luftlagerung, eine elektrische oder eine elektromagnetische Lagerung verbunden.

Entsprechend den zuvor beschriebenen Ausführungsbeispielen ist es auch im vorliegenden Fall wichtig, dass sowohl zwischen den Läufern 55 bzw. 56 und den Verbindungselementen 51 bzw. 61 als auch zwischen den Verbindungselementen 51 bzw. 61 und der beweglichen Komponente 57 des xy-Tisches 58 feste Verbindungen 53 bzw. 54 und 63 bzw. 64 vorgesehen sind.

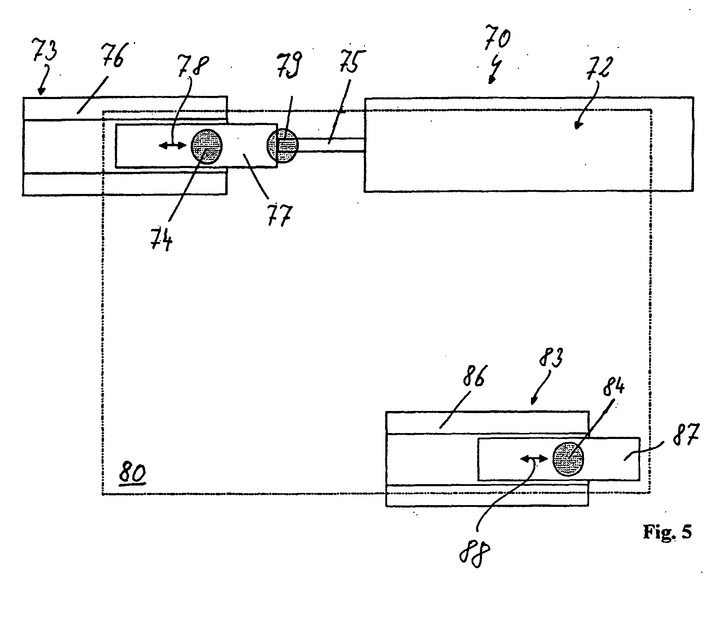

Das in Figur 5 gezeigte Ausführungsbeispiel 70 zeigt ein erstes Führungsmodul 73, das in einer Reihe vor dem Beschleunigungsnanoantrieb 72 angeordnet ist und ein zweites Führungsmodul 83, das parallel versetzt zum ersten Führungsmodul 73 angeordnet ist. Der Läufer 75 des Beschleunigungsnanoantriebs 72 hat eine feste mechanische Verbindung 79 zur beweglichen Komponente 77 des Führungsmoduls 73. Die bewegliche Komponente 77 hat darüber hinaus eine feste mechanische Verbindung 74 zu einem Verbindungselement 80, das beispielsweise eine Deckplatte oder ein offener Rahmen sein kann. Dieses Verbindungselement 80 hat eine feste mechanische Verbindung 84 zur beweglichen Komponente 87 des zweiten Führungsmoduls 83.

Die Bewegung des Läufers 75 führt somit zu einer Bewegung des Verbindungselementes 80 in Richtung der Pfeile 78 und 88 relativ zur stationären Komponente 76 des Führungsmoduls 73 bzw. 86 des Führungsmoduls 83.

Die Ausführungsbeispiele zeigen, dass sich beliebige Kombinationen aus einem oder mehreren Beschleunigungsnanoantrieben und einem oder mehreren linearen, drehenden oder mehrachsigen Führungsmodulen herstellen lassen.

## Patentansprüche

1. Positioniereinheit (1) mit einem Beschleunigungsnanoantrieb (2), der eine Auflösung von mindestens ± 10 nm aufweist und auf einen Läufer (5) nach dem Prinzip des Trägheitsantriebs oder durch Erzeugung mechanischer Pulswellen Beschleunigungen von über 10 G aufbringen kann und einem Modul (6, 7), das eine stationäre Komponente (6) und eine hierzu bewegliche Komponente (7) aufweist, die eine Masse von unter 500 g aufweist und relativ zum Antrieb (2) und zur stationären Komponente (6) beweglich gelagert ist, ***wobei*** der Läufer (5) und die bewegliche Komponente (7) des Moduls (6, 7) fest miteinander verbunden sind.

2. Positioniereinheit nach Anspruch 1, ***dadurch gekennzeichnet, dass*** der Antrieb (2) eine Positionierstrecke von mehr als 1 mm ermöglicht.

3. Positioniereinheit nach Anspruch 1 oder 2, ***dadurch gekennzeichnet, dass*** der Antrieb (2) eine Auflösung von mindestens ± 1 nm aufweist.

4. Positioniereinheit nach einem der vorhergehenden Ansprüche, ***dadurch gekennzeichnet, dass*** der Antrieb (2) Beschleunigungen von über 20 G, vorzugsweise über 40 G auf den Läufer (5) aufbringt.

5. Positioniereinheit nach einem der vorhergehenden Ansprüche, ***dadurch gekennzeichnet, dass*** der Antrieb (2) Beschleunigungen von unter 500 G, vorzugsweise von unter 200 G auf den Läufer aufbringt.

6. Positioniereinheit nach einem der vorhergehenden Ansprüche, ***dadurch gekennzeichnet, dass*** die bewegliche Komponente (57) des Moduls im Hinblick auf mehrere Freiheitsgrade beweglich gelagert ist.

7. Positioniereinheit nach einem der vorhergehenden Ansprüche, ***dadurch gekennzeichnet, dass*** die bewegliche Komponente (7) des Moduls eine Masse von unter 100 g aufweist.

8. Positioniereinheit nach einem der vorhergehenden Ansprüche, ***dadurch gekennzeichnet, dass*** die bewegliche Komponente (7) des Moduls eine Masse von über 0,2 g aufweist.

9. Positioniereinheit nach einem der vorhergehenden Ansprüche, ***dadurch gekennzeichnet, dass*** die feste Verbindung (9) im Wesentlichen spiel- und dämpfungsfrei ist.

10. Positioniereinrichtung mit mindestens zwei Positioniereinheiten (52, 62) nach einem der Ansprüche 1 bis 9, die fest mit der beweglichen Komponente (57) des Moduls verbunden sind.

## Claims

1. A positioning unit (1) with an acceleration nano-drive (2), which has a resolution of at least ±10 nm and applies accelerations of over 10 G to a runner (5) according to the principle of the inertial drive or by generating mechanical pulse waves, and a module (6, 7) having a stationary component (6) and a component (7) moveable relative thereto, which has a mass of under 500 g and is moveably mounted relative to the drive (2) and stationary component (6), wherein the runner (5) and the moveable component (7) of the module (6, 7) are rigidly connected with each other.

2. The positioning unit according to claim 1, **characterized in that** the drive (2) enables a positioning path of more than 1 mm.

3. The positioning unit according to claim 1 or 2, **characterized in that** the drive (2) has a resolution of at least ± 1 nm.

4. The positioning unit according to one of the preceding claims, **characterized in that** the drive (2) applies accelerations of over 20 G, preferably over 40 G, to the runner (5).

5. The positioning unit according to one of the preceding claims, **characterized in that** the drive (2) applies accelerations of under 500 G, preferably under 200 G, to the runner.

6. The positioning unit according to one of the preceding claims, **characterized in that** the moveable component (57) of the module is mounted so that it can move within several degrees of freedom.

7. The positioning unit according to one of the preceding claims, **characterized in that** the moveable component (7) of the module has a mass of below 100 g.

8. The positioning unit according to one of the preceding claims, **characterized in that** the moveable component (7) of the module has a mass of over 0.2 g.

9. The positioning unit according to one of the preceding claims, **characterized in that** the rigid connection (9) is essentially free of play and damping.

10. The positioning device with at least two positioning units (52, 62) according to one of claims 1 to 9, which are rigidly connected with the moveable component (57) of the module.

## Revendications

1. Unité de positionnement (1) avec une nanocommande d'accélération (2), qui présente une résolution de ± 10 nm et applique des accélérations supérieures à 10 G sur un rotor (5) selon le principe de la commande par inertie ou par production d'ondes d'impulsion mécaniques et un module (6, 7), qui présente une composante (6) stationnaire et une composante (7) mobile par rapport à la première, laquelle présente une masse inférieure à 500 g et est logée de façon mobile par rapport à la commande (2) et à la composante (6) fixe, moyennant quoi le rotor (5) et la composante (7) mobile du module (6, 7) sont reliés entre eux de façon fixe.

2. Unité de positionnement selon la revendication 1, **caractérisée en ce que** la commande (2) permet un tronçon de positionnement supérieur à 1 mm.

3. Unité de positionnement selon la revendication 1 ou 2, **caractérisée en ce que** la commande (2) présente une résolution d'au moins ± 1 mm.

4. Unité de positionnement selon l'une quelconque des revendications précédentes, **caractérisée en ce que** la commande (2) applique des accélérations supérieures à 20 G, de préférence supérieures à 40 G, sur le rotor (5) .

5. Unité de positionnement selon l'une quelconque des revendications précédentes, **caractérisée en ce que** la commande (2) applique des accélérations inférieures à 500 G, de préférence inférieures à 200 G, sur le rotor.

6. Unité de positionnement selon l'une quelconque des revendications précédentes, **caractérisée en ce que** la composante (57) mobile du module est logée de façon mobile par rapport à plusieurs degrés de liberté.

7. Unité de positionnement selon l'une quelconque des revendications précédentes, **caractérisée en ce que** la composante (7) mobile du module présente une masse inférieure à 100 g.

8. Unité de positionnement selon l'une quelconque des revendications précédentes, **caractérisée en ce que** la composante (7) mobile du module présente une masse supérieure à 0,2 g.

9. Unité de positionnement selon l'une quelconque des revendications précédentes, **caractérisée en ce que** la liaison (9) fixe est sensiblement sans jeu et sans amortissement.

10. Dispositif de positionnement avec au moins deux unités de positionnement (52, 62) selon l'une quelconque des revendications 1 à 9, qui sont reliées de façon fixe à la composante (57) mobile du module.
